# EUROPEAN PATENT SPECIFICATION

(11) **EP 0 746 101 B1**
(45) Date of publication and mention of the grant of the patent: **08.08.2001**
(21) Application number: 95830230.9
(22) Date of filing: 31.05.1995
(51) Int. Cl.: H03K 19/003, H03K 17/082

(54) **Circuit for detection and protection against short circuits for digital outputs**
Schaltung zum Erkennen von und Schutz vor Kurzschlüssen für digitale Ausgänge
Circuit de détection et de protection contre des court-circuits pour sorties numériques

(43) Date of publication of application: 04.12.1996
(73) Proprietor: STMicroelectronics S.r.l., 20041 Agrate Brianza (Milano) (IT); CO.RI.M.ME. CONSORZIO PER LA RICERCA SULLA MICROELETTRONICA NEL MEZZOGIORNO, 95121 Catania (IT)
(72) Inventor: Gola, Alberto, I-27043 Broni (Pavia) (IT); Leone, Via Terrazzano, 67, I-20017 Rho (Milano) (IT); Fucili, Giona, I-20013 Magenta (Milano) (IT); Milazzo, Patrizia, I-98124 Messina (IT)
(74) Representative: Botti, Mario

(56) References cited:
- US-A- 4 342 065
- PATENT ABSTRACTS OF JAPAN vol. 18, no. 161 (E-1526) 17 March 1994 & JP-A-05 335 926 (NEC CORP) 17 December 1993
- PATENT ABSTRACTS OF JAPAN vol. 8, no. 95 (E-242) (1532) 2 May 1984 & JP-A-59 012 625 (NIPPON DENKI K. K.)

## Description

This invention relates to sense and protection circuits for protecting integrated circuits against short circuits at their terminals, in particular to a sense and protection circuit for protection against short circuits at a logic signal output terminal.

As is known, signals of the logic type are associated with definite conditions of the potential at the output terminal, which potential generally can take but one of two distinct values.

Such values may either be that of the ground potential or the potential of a supply line to the integrated circuit, and normally correspond to a logic zero or a logic one.

Whereas several different types of protectors are used against short circuits either toward the supply or ground or the load for the output terminals of analog signals, the output terminals of logic signals are typically left unprotected against short circuits.

Usually, in fact, the typical supply conditions to integrated circuits having logic outputs are those of a low voltage, 3 or 5V, and small current, a few mA, so that a shorted output terminal toward ground or the supply may be no cause of special concern.

But whenever such supply conditions are departed from, as is the case with such up-to-date applications as the output stages of driver circuits for printing members of high-quality ink jet printers, values of dissipated power may easily be reached which can endanger an integrated circuit.

It should be noted that the direct incorporation of protection circuitry to an output stage of the logic type is inadvisable because this could affect its characteristics, and especially its speed.

A protection mode for the outputs of even power analog stages, based on the use of an external feedback loop between the output terminal of the stage and an input circuit node which is connected to the signal input via a capacitor, has been known.

An application of this kind is described, for instance, on page 265 of the "Designers' Guide to Power Products" Application Manual, 2nd Edition, June 1992, published by this applicant.

That solution involves, however, the provision of a capacitor of relatively large capacitance and, therefore, generally non-integratable to the device.

Disclosed in the US Patent No. 4,342,065 to Larson is a circuit for protecting an inhibitable tristate data driver from damage due to an over current. A logic comparator circuit compares input and output logic levels of the data driver, and inhibits the driver causing the output to go to a tristate if a fault occurs.

The technical problem underlying this invention is to provide a sense and protection circuit against short circuits for a digital output stage, in particular a stage operative to shift the output level of input logic signals.

This problem is solved by a sense and protection circuit against short circuits as previously indicated and defined in the characterizing part of the appended claims to this specification.

The features and advantages of a protection circuit according to the invention will be apparent from the following description of an embodiment thereof, given by way of non-limitative example with reference to the accompanying drawings.

In the drawings:
Figure 1 is a diagram showing, partly in block form, a sense and protection circuit against short circuits according to the invention, and
Figure 2 shows a driver circuit for ink jet printing members which incorporates a protection circuit according to the invention.

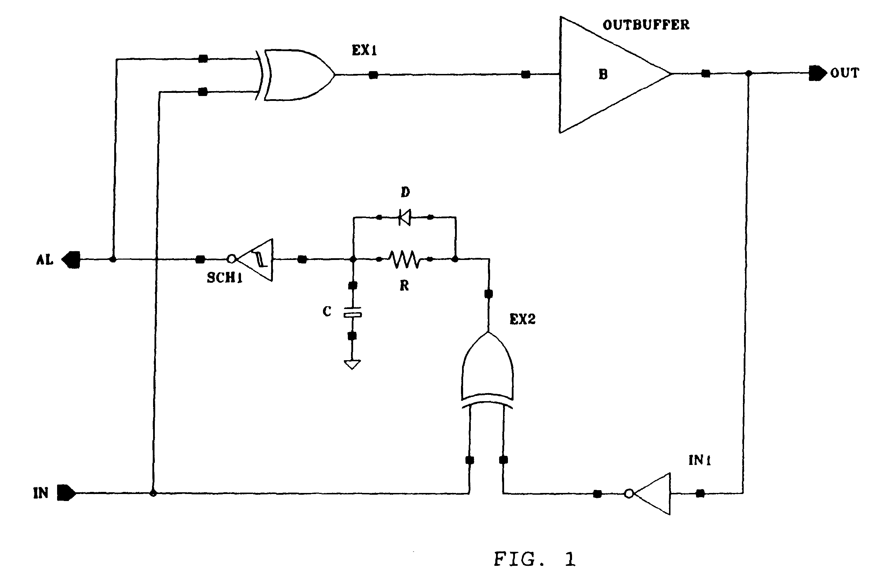

The circuit diagram shown in Figure 1 includes an output stage B operative to shift the level of a logic signal.

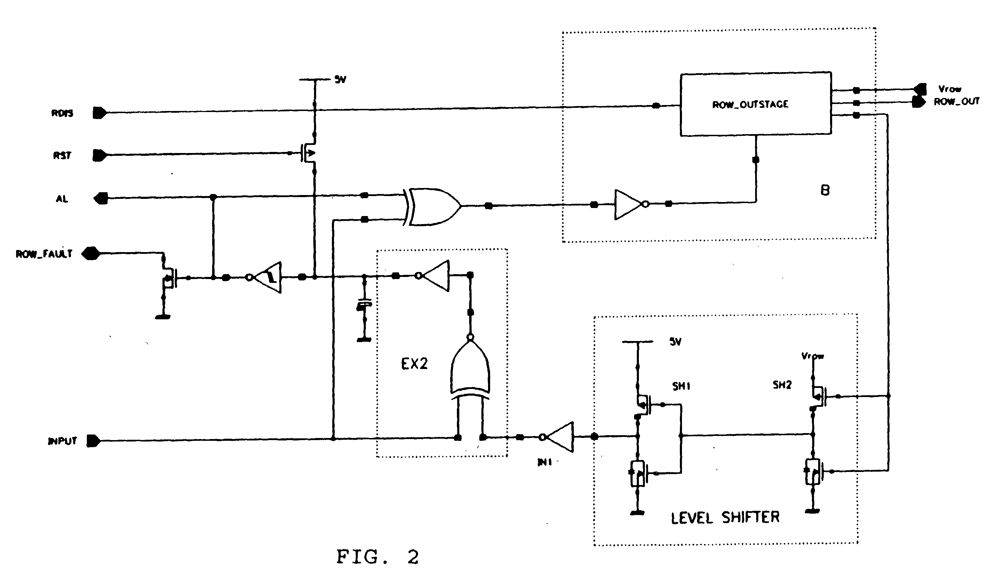

This output stage operates, in the embodiment shown in Figure 2 which concerns a driving arrangement for a printing head of a high-speed ink jet printer for computers, at output voltages which far exceed the typical value of 5V, and has a sense and protection circuit according to this invention connected thereto.

This protection circuit consists of a first circuit comprised of a logic gate EX1 of the exclusive OR type and which has an input terminal connected to an input node IN for the signals to be shifted in level and an output terminal connected to an input terminal of the output stage B.

A second circuit, comprised of a logic gate EX2 also of the exclusive OR type, has a first input terminal connected to the input node IN and a second input terminal connected, through an inverting circuit IN1, to an output terminal OUT of the output stage.

A second input terminal of the circuit EX1 is connected to an output terminal of a threshold type of comparator circuit SCH1 which, as shown in the Figure, may have dual thresholds, of the Schmitt trigger type.

The circuit SCH1 has an input terminal coupled to an output terminal of the circuit EX2 through delay circuitry providing a predetermined delay and comprising, in this case, a capacitor C, a resistor R, and a diode D in parallel with the resistor.

The comparator output may be coupled to a warning terminal AL.

The inventive circuit originates from the need to have a short circuit at a logic output sensed in a simple manner for protection thereagainst.

A logic output stage may be schematically represented by a buffer or interface circuit, either of the inverting or non-inverting type.

The solution is a completely separated one from the circuitry of the output stage which can, accordingly, be qualified as a non-inverting buffer for the purpose of explaining the protector operation.

In a CMOS output structure comprising an upper and a lower transistor which are complementary to each other and driven by the same signals, when the output is at a logic high and a short circuit occurs toward ground, the dissipated power would be given by Vcc*I_{D}, where I_{D} is the current that the upper transistor can carry, and Vcc is the supply voltage.

When the output is in a logic low state, a short circuit to ground would be of no harm because the potential difference across the conducting transistor is zero, as zero is, therefore, the power dissipated by it.

Exactly complementary is the instance where the short circuit is toward the power supply.

On the occurrence of a short circuit, it is desired that this condition be sensed circuit-wise and that the conduction conditions of the output stage be altered such that the potential difference across the active element (in a logic circuit, only one of the transistors would be on) be zero, thereby to implement a protective function.

In Figure 1, the output buffer is denoted by the character B (in the embodiment shown, it is a non-inverting type, but the dual case, i.e. the inverting one, can easily be reduced to this situation) and receives the input signal on a logic gate of the exclusive OR type (EX1).

The output signal is picked up by an inverting circuit (IN1) and supplied to one of the two inputs of another exclusive OR (EX2).

The idea on which this invention stands is one of having the output logic level compared to the input level: the two levels should be coincident for, otherwise, the event is to be regarded as abnormal.

The logic signal output to EX2 is passed to a filter comprising a diode D, a resistor R, and a capacitor C. The output from this filter drives a Scmitt trigger circuit SCH1.

The signal being supplied to a terminal AL is at one time an indicator of an abnormal situation and an output control signal. On the occurrence of a short circuit, the EXOR gate EX1 will invert the drive signal to the output stage, thereby cancelling the shorted condition.

Under "normal" conditions, the input of SCH1 would be high, and accordingly, the terminal AL would be in a low logic state and EX1 operating in the non-inverting mode, that is, with its output signal at the same logic level as its input.

The output buffer is only to transfer the signal to the device output.

With the input IN at a low logic level, AL also is at a low logic level, as is the buffer output.

At the inputs of EX2 there will be a low logic level and a high one; consequently, the output will be at a logic high, just as the input of SCH1, to confirm the logic zero on AL.

The components R, C and D form a unidirectional delay element in that the capacitor C is charged at a fast rate, at the power-on, and then discharged with a time constant RC. This network is directed to "mask off" the circuit for a longer time period than the propagation time of the output buffer.

In fact, assuming that the logic input IN moves from zero to one, the buffer output cannot switch to one at once. In this case, if this time interval were not masked, a false detection of a short circuit would occur.

The same signal appears at the inputs of EX2 throughout the period which corresponds to the delay of B; the output of EX2 goes to a low and begins to discharge the capacitor C through the resistor R.

By an appropriate selection of the time constant, the discharge can be terminated before the threshold of SCH1 is reached, and the capacitor is at once re-charged.

By converse, if the input IN (and consequently, the output OUT) is at a logic high, and a short circuit occurs toward ground, the output of B will be driven to ground and the current will take a value equal to that of the supply voltage divided by the output resistance of the p-channel transistor in the complementary transistor pair.

The output terminal of the inverting circuit IN1 goes over to a logic high, and EX2 output goes to zero, thereby beginning to discharge C through the resistor R.

If the short circuit is not removed, the discharge will continue until the threshold of SCH1 is reached, SCH1 output becoming high. Thus, EX1 will have both inputs at a "1" and respond by a logic low which propagates to the output OUT through B.

This output condition is a stable one, and will be retained even if the short circuit is removed.

Assuming that this occurs, nothing will change before the input IN goes from one over to zero; B will then be with its input at a logic high, but the output OUT is held low for a corresponding time period to the propagation delay; during this time interval, EX2 has one input at a zero and the other at a one, and its output will go over to "1", thereby charging C at once and restoring to the original conditions. It therefore is necessary that the input changes its state back to the original conditions.

Similar considerations apply to the instance of a short circuit toward the supply.

The inverter IN1 has a threshold centered around a mid-value of the supply, and this is the value that should be attained in an overloaded condition.

For example, if the two output transistors of the buffer have a resistance of 50 ohms, then the protector would trip on when the overload equals a load resistance of 50 ohms or less.

As an example, shown in Figure 2 is an embodiment of the protection circuit according to the invention as implemented in a device from this applicant. The block B in phantom lines corresponds to the output buffer, EX2 being split into an exclusive NOR and an inverting circuit.

The latter (I94) performs the functions of R and D in Figure 1 and can charge the capacitor at a fast rate, while the discharge current is quite small.

A transistor gives an external warning of an overload, while SH1 and SH2 have been included to provide a level shifting function, since the output circuit (ROW_OUTSTAGE) is at something like 16V.

To close with, a circuit according to the invention does provide the overload sense and protection function, regardless of the output stage layout and without affecting its functional characteristics.

It is simple and fast, so much so that its operation must be masked during the propagation times, and it is readily integratable together with the output stage.

## Claims

1. A protection circuit against short circuits for an output stage (B) of an integrated circuit, operative to shift the output level of logic signals and having at least one input terminal and one output terminal, the input terminal of the output stage being coupled to an input node (IN) for the logic signals, comprising a first logic circuit of the exclusive OR type having at least first and second input terminals and an output terminal, the first and second input terminals of the first logic gate circuit (EX2) being respectively coupled to the signal input node (IN) and the output terminal of the output stage (B), characterized in that it comprises a second (EX1) logic gate circuit of the exclusive OR type, having at least first and second input terminals and an output terminal, the first input terminal and the output terminal of the second logic gate circuit (EX1) being respectively coupled to the signal input node (IN) and the input terminal of the output stage (B), the second input terminal of the second logic gate circuit being coupled to an output terminal of a threshold comparator circuit (SCH1) having an input terminal coupled to the output terminal of the first logic gate circuit (EX2) through a filter means (C,R,D) providing a predetermined delay.

2. A protection circuit according to Claim 1, characterized in that the comparator circuit (SCH1) is of the Schmitt trigger type.

3. A protection circuit according to Claim 1, characterized in that the comparator circuit (SCH1) comprises an inverting circuit.

4. A protection circuit according to Claim 1, characterized in that the filter means providing a predetermined delay comprises a capacitor (C) connected between the input terminal of the comparator circuit (SCH1) and a reference potential.

5. A protection circuit according to Claim 4, characterized in that the filter means providing a predetermined delay comprises a resistor (R) and a diode (D) connected in parallel with each other between the output terminal of the first logic gate circuit (EX2) and the input terminal of the comparator circuit (SCH1).

6. A protection circuit according to Claim 4, characterized in that the filter means providing a predetermined delay comprises an inverting circuit connected between the output terminal of the first logic gate circuit (EX2) and the input terminal of the comparator circuit (SCH1).

7. A protection circuit according to any of Claims 1, 2, 3, 4, 5 and 6 for an output stage of the non-inverting type, characterized in that an inverting circuit (IN1) is connected between the output terminal (OUT) of the output stage (B) and the second input terminal of the first logic gate circuit (EX2).

8. A protection circuit according to any of Claims 1, 2, 3, 4, 5, 6 and 7, characterized in that the output terminal of the comparator circuit (SCH1) is coupled to a short circuit warning terminal (AL).

9. An ink jet printer for computers, characterized in that it comprises a driver circuit for printing members having a final stage which incorporates a protection circuit as claimed in any of Claims 1, 2, 3, 4, 5, 6, 7 and 8.

## Patentansprüche

1. Schutzschaltung zum Schutz vor Kurzschlüssen für eine Ausgangsstufe (B) einer integrierten Schaltung, ausgebildet zum Verschieben des Ausgangspegels logischer Signale und mit mindestens einem Eingangsanschluß und einem Ausgangsanschluß, von denen der Eingangsanschluß der Ausgangsstufe mit einem Eingangsknoten (IN) für die logischen Signale gekoppelt ist, umfassend eine erste Logikschaltung vom Exklusiv-ODER-Typ mit mindestens einem ersten und einem zweiten Eingangsanschluß und einem Ausgangsanschluß, wobei der erste und der zweite Eingangsanschluß der ersten logischen Gatterschaltung (EX2) an den Signaleingangsknoten (IN) und den Ausgangsanschluß der Ausgangsstufe (B) gekoppelt ist, dadurch gekennzeichnet, daß sie eine zweite (EX1) logische Gatterschaltung vom Exklusiv-ODER-Typ aufweist, die mindestens einen ersten und einen zweiten Eingangsanschluß und einen Ausgangsanschluß besitzt, von denen der erste Eingangsanschluß und der Ausgangsanschluß dieser zweiten logischen Gatterschaltung (EX1) mit dem Signaleingangsknoten (IN) bzw. dem Eingangsanschluß der Ausgangsstufe (B) gekoppelt sind, der zweite Eingangsanschluß der zweiten logischen Gatterschaltung an einen Ausgangsanschluß einer Schwellenwertvergleicherschaltung (SCH1) angeschlossen ist, deren Eingangsanschluß an den Ausgangsanschluß der ersten logischen Gatterschaltung (EX2) über eine Filtereinrichtung (C, R, D), die eine vorbestimmte Verzögerung schafft, angeschlossen ist.

2. Schaltung nach Anspruch 1, dadurch gekennzeichnet, daß die Vergleicherschaltung (SCH1) vom Schmitt-Trigger-Typ ist.

3. Schutzschaltung nach Anspruch 1, dadurch gekennzeichnet, daß die Vergleicherschaltung (SCHI) eine Negatorschaltung enthält.

4. Schutzschaltung nach Anspruch 1, dadurch gekennzeichnet, daß die eine vorbestimmte Verzögerung schaffende Filtereinrichtung einen zwischen dem Eingangsanschluß der Vergleicherschaltung (SCH1) und einem Referenzpotential liegenden Kondensator (C) aufweist.

5. Schutzschaltung nach Anspruch 4, dadurch gekennzeichnet, daß die eine vorbestimmte Verzögerung schaffende Filtereinrichtung einen Widerstand (R) und eine Diode (D) aufweist, die zueinander zwischen dem Ausgangsanschluß der ersten logischen Gatterschaltung (EX2) und dem Einganganschluß der Vergleicherschaltung (SCH1) parallel geschaltet sind.

6. Schutzschaltung nach Anspruch 4, dadurch gekennzeichnet, daß die eine vorbestimmte Verzögerung schaffende Filtereinrichtung eine Negatorschaltung enthält, die zwischen den Ausgangsanschluß der ersten logischen Gatterschaltung (EX2) und den Eingangsanschluß der Vergleicherschaltung (SCH1) gelegt ist.

7. Schutzschaltung nach einem der Ansprüche 1, 2, 3, 4, 5 und 6 für eine Ausgangsstufe vom nicht-invertierenden Typ, dadurch gekennzeichnet, daß eine Negatorschaltung (IN1) zwischen den Ausgangsschaltung (OUT) der Ausgangsstufe (B) und den zweiten Eingangsanschluß der ersten logischen Gatterschaltung (EX2) gelegt ist.

8. Schutzschaltung nach einem der Ansprüche 1, 2, 3, 4, 5, 6 und 7, dadurch gekennzeichnet, daß der Ausgangsanschluß der Vergleicherschaltung (SCH1) an einen Kurzschluß-Warnanschluß (AL) gekoppelt ist.

9. Tintenstrahldrucker für Rechner, dadurch gekennzeichnet, daß er eine Treiberschaltung für Druckelemente mit einer Endstufe enthält, welche eine Schutzschaltung gemäß einem der Ansprüche 1, 2, 3, 4, 5, 6, 7 und 8 beinhaltet.

## Revendications

1. Circuit de protection contre les courts-circuits pour un étage de sortie (B) d'un circuit intégré, opérationnel pour décaler le niveau de sortie des signaux logiques et ayant au moins une borne d'entrée et une borne de sortie, la borne d'entrée de l'étage de sortie étant couplée à un noeud d'entrée (IN) pour les signaux logiques, comprenant un premier circuit porte logique du type OU exclusif ayant au moins des première et deuxième bornes d'entrée et une borne de sortie, les première et deuxième bornes d'entrée du premier circuit porte logique (EX2) étant respectivement couplées au noeud d'entrée de signal (IN) et à la borne de sortie de l'étage de sortie (B), caractérisé en ce qu'il comprend un deuxième circuit porte logique (EX1) du type OU exclusif, ayant au moins des première et deuxième bornes d'entrée et une borne de sortie, la première borne d'entrée et la borne de sortie du deuxième circuit porte logique (EX1) étant respectivement couplées au noeud d'entrée du signal (IN) et à la borne d'entrée de l'étage de sortie (B), la deuxième borne d'entrée du deuxième circuit porte logique étant couplée à une borne de sortie d'un circuit comparateur à seuil (SCH1) dont une borne d'entrée est couplée à la borne de sortie du premier circuit porte logique (EX2) par des moyens formant filtre (C, R, D) fournissant un retard prédéterminé.

2. Circuit de protection selon la revendication 1, caractérisé en ce que le circuit comparateur (SCH1) est du type trigger de Schmitt.

3. Circuit de protection selon la revendication 1, caractérisé en ce que le circuit comparateur (SCH1) comprend un circuit inverseur.

4. Circuit de protection selon la revendication 1, caractérisé en ce que les moyens formant filtre fournissant un retard prédéterminé comprennent un condensateur (C) entre la borne d'entrée du circuit comparateur (SCH1) et un potentiel de référence.

5. Circuit de protection selon la revendication 4, caractérisé en ce que les moyens formant filtre fournissant un retard prédéterminé comprennent une résistance (R) et une diode (D) connectées en parallèle entre la borne de sortie du premier circuit porte logique (EX2) et la borne d'entrée du circuit comparateur (SCH1).

6. Circuit de protection selon la revendication 4, caractérisé en ce que les moyens formant filtre fournissant un retard prédéterminé comprennent un circuit inverseur connecté entre la borne de sortie du premier circuit porte logique (EX2) et la borne d'entrée du circuit comparateur (SCH1).

7. Circuit de protection selon l'une des revendications 1, 2, 3, 4, 5 et 6 pour un étage de sortie du type non inverseur, caractérisé en ce qu'un circuit inverseur (IN1) est connecté entre la borne de sortie (OUT) de l'étage de sortie (B) et la deuxième borne d'entrée du premier circuit porte logique (EX2).

8. Circuit de protection selon l'une des revendications 1, 2, 3, 4, 5, 6 et 7, caractérisé en ce que la borne de sortie du circuit comparateur (SCH1) est couplée à une borne d'avertissement de courts-circuits (AL).

9. Imprimante à jet d'encre pour ordinateurs, caractérisée en ce qu'elle comprend un circuit de commande pour les éléments d'impression ayant un dernier étage incorporant un circuit de protection selon l'une quelconque des revendications 1, 2, 3, 4, 5, 6, 7 et 8.
